# EUROPEAN PATENT SPECIFICATION

(11) **EP 2 196 077 B1**
(45) Date of publication and mention of the grant of the patent: **15.02.2012**
(21) Application number: 08806263.3
(22) Date of filing: 15.09.2008
(51) Int. Cl.: H05K 9/00, G01T 1/00

(54) **PROTECTION OF ELECTRONIC DEVICES**
SCHUTZ ELEKTRONISCHER EINRICHTUNGEN
PROTECTION DE DISPOSITIFS ÉLECTRONIQUES

(30) Priority: 13.09.2007 GB 0717876
(43) Date of publication of application: 16.06.2010
(73) Proprietor: Cassidian Limited, Coedkernew, Newport NP10 8FZ (GB)
(72) Inventor: TURTON, Brian, Charles, Hargrave, Newport NP10 8FZ (GB)
(74) Representative: Critten, Matthew Peter
(86) International application number: PCT/GB2008/003107
(87) International publication number: WO 2009/034347

(56) References cited:
- EP-A- 0 375 120
- GB-A- 1 236 148
- US-A1- 2004 016 913

## Description

This invention relates to the protection of electronic devices from radiation, such as high energy gamma ray pulses produced by a nuclear explosion.

Gamma radiation causes the p-n junctions of semiconductor devices to pass a current. As is known in the art, the effect of a large number of semiconductor transistors conducting at the same time can very quickly lead to significant damage to an integrated circuit.

For example, US 7,196,333 describes a detector of radiation which uses a composite material, and a process of manufacturing the detector. The detector includes layers of a semiconducting composite material including a host matrix made of a polymer and semiconducting-type guest particles dispersed through the host matrix, means for creating an electric field in the layers, and a stack of sheets of a first material emitting particles by interaction with the radiation, the layers alternating with the sheets, each of the layers being associated with one of the sheets, the stack having opposite faces, each containing the edges of the sheets and layers. The means for creating includes, for each layer, a group of parallel and conductive tracks which extend from one face to the other, parallel to this layer, and which are in contact with it.

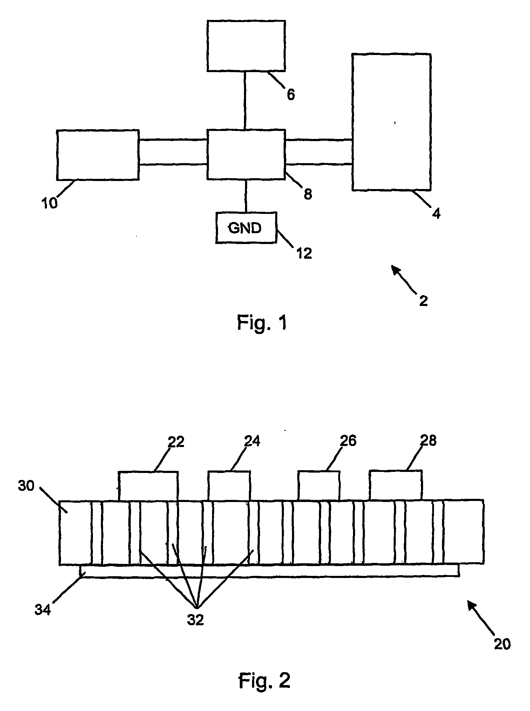

Figure 1 shows a highly schematic circuit, indicated generally by the reference numeral 2, intended to address the problem outlined above. The system 2 comprises a circuit portion 4 that implements the desired functionality of the circuit 2. In addition, the system 2 comprises a radiation sensor 6, a switching arrangement 8, a power source 10 and a ground connection 12. In the event that the radiation sensor 6 detects the presence of potentially damaging gamma radiation, the switching arrangement 8 breaks the connection between the power source 10 and the circuit portion 4.

By way of example, EP 0 375 120 describes a nuclear event detector in which a photodiode is used as a radiation sensing device in an arrangement having some similarities with that shown in Figure 1.

The systems of Figure 1 and that described in EP 0 375 120 suffer from a fundamental problem in that they are not able to remove power until after potentially damaging radiation has been detected by the radiation sensor 6.

Moreover, many prior art arrangements, such as that of Figure 1 merely prevent power from being supplied to the circuit 4. Charged stored capacitively within the circuit 4 is not removed and can still result in damage to the circuit 4. A more sophisticated approach to the problem involves connecting capacitive circuit elements to ground. However, designing a circuit to enable such grounding of capacitive circuit elements has cost implications, both in terms of design costs and implementation costs, as well as in terms of time.

The present invention seeks to address at least some of the problems outlined above.

The present invention provides a circuit board having a plurality of electrical connections, the circuit board further comprising a composite having a resistance that is variable due to quantum tunnelling, wherein the composite is arranged in physical connection with at least some of said electrical connections, whereby, in response to high energy electromagnetic radiation, said connections are electrically connected through the said composite. Preferably, the said composite is a quantum tunnelling composite.

The present invention also provides a method comprising the step of applying a composite having a resistance that is variable due to quantum tunnelling between at least some of a plurality of electrical connections on a circuit board such that, in the event of a high energy electromagnetic radiation being received, the said electrical connections are electrically connected by the said composite. Preferably, the said composite is a quantum tunnelling composite.

By providing a composite, such as a quantum tunnelling composite, between connections of an electrical circuit, the connections can be short-circuited in the presence of potentially dangerous high energy electromagnetic pulses. In this way, charge can be quickly removed from the circuit, so that there is little or no charge for any p-n junction that is activated to pass.

In one form of the invention, the quantum tunnelling composite comprises one or more metals and one or more elastomeric binders.

By way of example, the said high energy electromagnetic radiation may include gamma radiation, such as high energy gamma ray pulses that follow a nuclear explosion.

A property of quantum tunnelling composites is that their resistance varies enormously in response to electromagnetic radiation. For example, in a conducting (or "tunnelling") state, the said composite has a resistance of 1 ohm or less, whereas, in a non-conducting (or "non-tunnelling") state, the composite may have a resistance of 10 M-ohm. Of course, composite with different resistance ranges (such as conducting resistances of 5 ohms or 10 ohms and non-conducting resistances of 1 M-ohm or 100 M-ohms) are feasible and could be used with the present invention.

A problem that can be encountered with quantum tunnelling compositing is latching, in which the composite remains in a conducting state, even after the source of radiation is removed. This problem can be addressed by applying vibrations to the composite. In one form of the invention, a loudspeaker is provided to provide the vibrations. The loudspeaker may be activated each time a source of electromagnetic radiation is no longer present. Alternatively, the loudspeaker may only be activated when a latched condition is detected. Of course, any object that provides a suitable vibration could be used in place of the loudspeaker; for example, a simple piezoelectric device could be used.

The present invention may also provide a nuclear event detector, which may, for example, be implemented using a quantum tunnelling composite. The nuclear event detector may be used to provide a signal for disabling a power supply associated with said circuit board. This may take the form of electrically disconnecting the power supply from the remainder of a circuit carried by the circuit board or may take the form of disabling the power supply itself.

The nuclear event detector may also be used as the means by which the vibration device mentioned above is activated.

Devices and methods in accordance with the invention will now be described, by way of example only, with reference to the accompanying schematic drawings in which:
Fig. 1 shows a prior art circuit;
Fig. 2 is a cross-section of a circuit in accordance with an aspect of the present invention; and
Fig. 3 shows a circuit in accordance with an aspect of the present invention.

Composite materials consisting of metals and elastomeric binders that provide highly effective pressure sensors are known in the art. In such devices, in the absence of pressure, the conductive elements within the composite are too far apart to conduct electricity, but, when pressure is applied, the conductive elements move closer together and electricity can tunnel across the insulator. The effect is far more pronounced than would be expected from non-quantum effects alone. Such composites are known in the art as quantum tunnelling composites. By way of example, such composites are described in WO 98/33193.

Quantum tunnelling composites are available from Peratech Limited, Hethersett House, Roecliffe Business Center, Roecliffe, North Yorkshire YO51 9NE, England (www.peratech.co.uk). For example, Peratech provide a number of products that can be used as pressure sensors. Two such products are quantum tunnelling cables and quantum tunnelling pills available from Maplin Electronics Ltd, National Distribution Centre, Valley Road, Wombwell, Barnsley, South Yorkshire S73 0BS, England (www.maplin.co.uk).

Whilst the use of quantum tunnelling composites as pressure sensors is well known in the art, the resistance of such composites is also variable in response to electromagnetic radiation, including gamma radiation.

The inventor has realised that quantum tunnelling composites offer a potential solution to the problems outlined above. A quantum tunnelling composite can be provided between electrical connections of a circuit board, since, in a normal state, the composite is highly resistive (perhaps 100MΩ) and therefore has a negligible effect on the circuit. However, in response to a high energy gamma ray pulse, the composite quickly becomes conducting (having a resistance of perhaps 1Ω). This property can be used to provide a switching arrangement that is much more effective than that described above with reference to Figure 1.

Figure 2 is a highly schematic cross-section of a circuit board, indicated generally by the reference numeral 20, in accordance with the present invention. The circuit board 20 has a main body 30 with a plurality of circuit elements 22, 24, 26 and 28 mounted on the upper surface of the main body 30. A number of holes (vias) 32 are provided in the main body 30 to allow for electrical connections to be provided between different parts of the board. A layer of a quantum tunnelling composite 34 is provided on the under side of the main body 30.

In the normal use of the circuit 20, the quantum tunnelling composite 34 has a very high resistivity and has a negligible effect on the operation of the circuit 20. However, in response to a high energy gamma ray pulse, the composite 34 very quickly becomes conductive and provides an electrical connection between the holes 32. In this manner, different parts of the circuit 20 can be electrically connected very quickly in response to a high energy gamma ray pulse in order to remove charge from the circuit.

Thus, in the event of a nuclear explosion, charge can be quickly removed from the elements of the circuit 20 in order to reduce the likelihood of damage being caused to the circuit. Furthermore, as soon as the level of gamma radiation drops below a predetermined level, the composite 32 returns to a highly insulating mode and the circuit can function normally again.

It should be noted that the arrangement of Figure 2 does not require a nuclear event detector. Accordingly, the arrangement is simpler, quicker and more effective than the arrangement described with reference to Figure 1. A further advantage is the lack of need to substantially modify the design of a circuit with gamma radiation protection in mind.

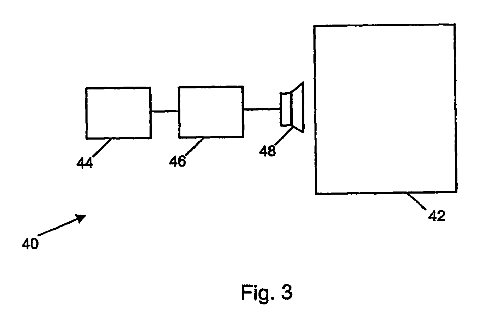

A potential problem with the arrangement of Figure 2 is that the composite 34 can, in some circumstances, become latched in a conducting mode. Thus, when gamma radiation is no longer present, there is a risk that the composite can remain conducting and prevent the normal working of the circuit 20. Figure 3 shows a circuit, indicated generally by the reference numeral 40, that can be used to address this problem. The circuit 40 comprises a protected circuit 42 similar to the arrangement of Figure 2. The protected circuit 42 therefore includes a quantum tunnelling composite (not shown) that is prone to latching as described above. The circuit 40 also comprises a nuclear event detector 44, a controller 46 and a loudspeaker 48.

As described above with reference Figure 2, in response to high energy gamma radiation, the quantum tunnelling composite associated with the protected circuit 42 will enter a conductive state, thereby protecting that circuit. The presence and absence of gamma radiation is also detected by the nuclear event detector 44, which provides a suitable signal to controller 46. In the event that the composite is latched in a conducting state when the nuclear event detector 44 indicates that gamma radiation is no longer present, the loudspeaker 48 is activated under the control of the controller 46. In one form of the invention, a quantum tunnelling composite is used as the nuclear event detector 44. The nuclear event detector 44 can also be used to turn off the power supply to the circuit if desired.

It is known in the art that composite can be taken out of a latched condition using a simple vibration. Thus, the vibrations of the loudspeaker can be used to take the composite out of the latched condition so that the circuit 42 can function normally.

In the embodiment of the invention described above, a single layer board has been described. This is not essential; for example, the invention could be used with multiple layer boards. The quantum tunnelling composite may or may not form one layer of such a multiple layer board.

## Claims

1. A circuit board (20) for the protection of electronic devices from radiation comprising a main body (30) with a plurality of circuit elements (22, 24, 26, 28) and a plurality of electrical connections,
**characterized in that** the circuit board further comprises a quantum tunnelling composite (34) which changes from a non-conducting state to a conducting state in response to high energy electromagnetic radiation, wherein the composite (34) is arranged in physical connection with at least some of said electrical connections, whereby, in response to high energy electromagnetic radiation said connections are electrically connected through the said composite.

2. A circuit board as claimed in claim 1, wherein said quantum tunnelling composite comprises one or more metals and one or more elastomeric binders.

3. A circuit board as claimed in any preceding claim, wherein said high energy electromagnetic radiation comprises gamma radiation.

4. A circuit board as claimed in any preceding claim, wherein, in a conducting state, the said composite (34) has a resistance of 1 ohm or less.

5. A circuit board as claimed in any preceding claim, wherein, in a non-conducting state, the said composite (34) has a resistance in excess of 10 M-ohm.

6. A circuit board as claimed in any preceding claim, further comprising a nuclear event detector (44).

7. A circuit board as claimed in claim 6, wherein said nuclear event detector (44) provides a signal for disabling a power supply associated with said circuit board.

8. A circuit board as claimed in any preceding claim, further comprising a vibration device that is activated when high energy electromagnetic radiation is no longer present.

9. A circuit board as claimed in claim 8, wherein said vibration device is a loudspeaker (48).

10. A circuit board as claimed in claim 8 or claim 9, further comprising a nuclear event detector (44) for providing a control signal to control the operation of said vibration device.

11. A method for the protection of electronic devices from radiation comprising the step of applying a quantum tunnelling composite (34) which changes from a non-conducting state to a conducting state in response to high energy electromagnetic radiation between at least some of a plurality of electrical connections on a circuit board (20) such that, in the event of a high energy electromagnetic radiation being received, the said electrical connections are electrically connected by the said composite (34).

12. A method as claimed in claim 11, wherein said composite (34) is applied as a layer.

13. A method as claimed in claim 12, wherein said quantum tunnelling composite (34) is applied by sputtering.

14. A method as claimed in any one of claims 11 to 13, wherein said high energy electromagnetic radiation comprises gamma radiation.

15. A method as claimed in any one of claims 11 to 14, wherein said step of applying a composite includes providing said composite (34) between a subset of the said electrical connections.

16. A method as claimed in any one of claims 11 to 15, further comprising the step of providing a vibration in the event that the composite (34) becomes latched in a conducting state.

## Patentansprüche

1. Leiterplatte (20) für den Schutz elektronischer Vorrichtungen vor Strahlung, die einen Hauptkörper (30) mit mehreren Schaltungselementen (22, 24, 26, 28) und mehreren elektrischen Verbindungen umfasst,
**dadurch gekennzeichnet, dass** die Leiterplatte ferner einen Quantentunnel-Verbundstoff (34) umfasst, der in Reaktion auf hochenergetische elektromagnetische Strahlung von einem nicht leitenden Zustand in einen leitenden Zustand wechselt, wobei der Verbundstoff (34) in einer physikalischen Verbindung mit wenigstens einigen der elektrischen Verbindungen angeordnet ist, wobei die Verbindungen in Reaktion auf hochenergetische elektromagnetische Strahlung durch den Verbundstoff elektrisch verbunden werden.

2. Leiterplatte nach Anspruch 1, wobei der Quantentunnel-Verbundstoff ein oder mehrere Metalle und ein oder mehrere elastomere Bindemittel umfasst.

3. Leiterplatte nach einem vorhergehenden Anspruch, wobei die hochenergetische elektromagnetische Strahlung Gammastrahlung umfasst.

4. Leiterplatte nach einem vorhergehenden Anspruch, wobei der Verbundstoff (34) in einem leitenden Zustand einen Widerstand von 1 Ohm oder weniger hat.

5. Leiterplatte nach einem vorhergehenden Anspruch, wobei der Verbundstoff (34) in einem nicht leitenden Zustand einen Widerstand von mehr als 10 M-Ohm hat.

6. Leiterplatte nach einem vorhergehenden Anspruch, die ferner einen Nuklearereignis-Detektor (44) umfasst.

7. Leiterplatte nach Anspruch 6, wobei der Nuklearereignis-Detektor (44) ein Signal bereitstellt, um eine der Leiterplatte zugeordnete Leistungsversorgung zu sperren.

8. Leiterplatte nach einem vorhergehenden Anspruch, die ferner eine Vibrationsvorrichtung umfasst, die aktiviert wird, wenn hochenergetische elektromagnetische Strahlung nicht mehr länger vorhanden ist.

9. Leiterplatte nach Anspruch 8, wobei die Vibrationsvorrichtung ein Lautsprecher (48) ist.

10. Leiterplatte nach Anspruch 8 oder Anspruch 9, die ferner einen Nuklearereignis-Detektor (44) umfasst, um ein Steuersignal bereitzustellen, um den Betrieb der Vibrationsvorrichtung zu steuern.

11. Verfahren für den Schutz elektromagnetischer Vorrichtungen vor Strahlung, das den Schritt des Aufbringens eines Quantentunnel-Verbundstoffs (34) umfasst, der in Reaktion auf hochenergetische elektromagnetische Strahlung zwischen wenigstens einigen von mehreren elektrischen Verbindungen auf einer Leiterplatte (20) von einem nicht leitenden Zustand in einen leitenden Zustand wechselt, so dass in dem Fall, in dem hochenergetische elektromagnetische Strahlung empfangen wird, die elektrischen Verbindungen durch den Verbundstoff (34) elektrisch verbunden werden.

12. Verfahren nach Anspruch 11, wobei der Verbundstoff (34) als eine Schicht aufgebracht wird.

13. Verfahren nach Anspruch 12, wobei der Quantentunnel-Verbundstoff (34) durch Katodenzerstäubung aufgebracht wird.

14. Verfahren nach einem der Ansprüche 11 bis 13, wobei die hochenergetische elektromagnetische Strahlung Gammastrahlung umfasst.

15. Verfahren nach einem der Ansprüche 11 bis 14, wobei der Schritt des Aufbringens eines Verbundstoffs das Vorsehen des Verbundstoffs (34) zwischen einer Untermenge der elektrischen Verbindungen umfasst.

16. Verfahren nach einem der Ansprüche 11 bis 15, das ferner den Schritt des Vorsehens von Vibrationen umfasst, falls der Verbundstoff (34) in einem leitenden Zustand verriegelt.

## Revendications

1. Carte de circuit imprimé (20) destinée à protéger des dispositifs électroniques contre un rayonnement comprenant un corps principal (30) avec une pluralité d'éléments de circuit (22, 24, 26, 28) et une pluralité de connexions électriques;
**caractérisée en ce que** la carte de circuit imprimé comprend en outre un composite à effet tunnel (34) qui passe d'un état non conducteur à un état conducteur en réponse à un rayonnement électromagnétique à haute énergie, dans laquelle le composite (34) est agencé en connexion physique avec certaines au moins desdites connexions électriques, grâce à quoi, en réponse à un rayonnement électromagnétique à haute énergie, lesdites connexions sont connectées de manière électrique par l'intermédiaire dudit composite.

2. Carte de circuit imprimé selon la revendication 1, dans laquelle ledit composite à effet tunnel comprend un ou plusieurs métaux et un ou plusieurs liants élastomères.

3. Carte de circuit imprimé selon l'une quelconque des revendications précédentes, dans laquelle ledit rayonnement électromagnétique à haute énergie comprend un rayonnement gamma.

4. Carte de circuit imprimé selon l'une quelconque des revendications précédentes, dans laquelle, dans un état conducteur, ledit composite (34) présente une résistance égale ou inférieure à 1 ohm.

5. Carte de circuit imprimé selon l'une quelconque des revendications précédentes, dans laquelle, dans un état non conducteur, ledit composite (34) présente une résistance supérieure à 10 mégohms.

6. Carte de circuit imprimé selon l'une quelconque des revendications précédentes, comprenant en outre un détecteur d'événement nucléaire (44).

7. Carte de circuit imprimé selon la revendication 6, dans laquelle ledit détecteur d'événement nucléaire (44) fournit un signal destiné à désactiver une alimentation associée à ladite carte de circuit imprimé.

8. Carte de circuit imprimé selon l'une quelconque des revendications précédentes, comprenant en outre un dispositif à vibrations qui est activé lorsque le rayonnement électromagnétique à haute énergie n'est plus présent.

9. Carte de circuit imprimé selon la revendication 8, dans laquelle ledit dispositif à vibrations est un haut-parleur (48).

10. Carte de circuit imprimé selon la revendication 8 ou la revendication 9, comprenant en outre un détecteur d'événement nucléaire (44) destiné à fournir un signal de commande de façon à commander le fonctionnement dudit dispositif à vibrations.

11. Procédé destiné à protéger des dispositifs électroniques contre un rayonnement, comprenant une étape consistant à appliquer un composite à effet tunnel (34) qui passe d'un état non conducteur à un état conducteur en réponse à un rayonnement électromagnétique à haute énergie, entre certaines au moins d'une pluralité de connexions électriques sur une carte de circuit imprimé (20) de telle sorte que lesdites connexions électriques, dans le cas de la réception d'un rayonnement électromagnétique à haute énergie, soient connectées de manière électrique par ledit composite (34).

12. Procédé selon la revendication 11, dans lequel ledit composite (34) est appliqué sous la forme d'une couche.

13. Procédé selon la revendication 12, dans lequel ledit composite à effet tunnel (34) est appliqué par pulvérisation.

14. Procédé selon l'une quelconque des revendications 11 à 13, dans lequel ledit rayonnement électromagnétique à haute énergie comprend un rayonnement gamma.

15. Procédé selon l'une quelconque des revendications 11 à 14, dans lequel ladite étape consistant à appliquer un composite comprend une étape consistant à fournir ledit composite (34) entre un sous-ensemble desdites connexions électriques.

16. Procédé selon l'une quelconque des revendications 11 à 15, comprenant en outre une étape consistant à fournir des vibrations dans le cas où le composite (34) se verrouille dans un état conducteur.
